# EUROPEAN PATENT APPLICATION

(11) **EP 3 223 254 A1**
(43) Date of publication of application: **27.09.2017**
(21) Application number: 16200342.0
(22) Date of filing: 23.11.2016
(51) Int. Cl.: G08C 19/28, H01L 35/28

(54) **REMOTE CONTROL DEVICE**

(30) Priority: 24.03.2016 CN 201610173310
(71) Applicant: Beijing Xiaomi Mobile Software Co., Ltd., Beijing 100085 (CN)
(72) Inventor: LIU, Dongxu, Beijing 100085 (CN); WANG, Yi, Beijing 100085 (CN); CHEN, Qiaoyu, Beijing 100085 (CN)
(74) Representative: Sackin, Robert

(57) **Abstract**

A remote control device is provided. The remote control device includes a shell (1) configured with a thermoelectric generation module (3), a central processor (2), a button module (4) and a RF module (5). The thermoelectric generation module (3) is connected with each of the other modules (2, 4 and 5). The central processor (2) is connected with the button module (4) and the RF module (5). The thermoelectric generation module (3) includes an electricity generation unit (31). The electricity generation unit (31) includes two metal sheets (311 and 312) which are made of different materials and form a closed loop circuit via two connection points (A and B). The electricity generation unit (31) is able to generate a thermoelectromotive force based on a temperature difference between the two connection points (A and B), and powers the other modules (2, 4 and 5) by the thermoelectromotive force.

## Description

### FIELD

The present disclosure generally relates to the technical field of wireless remote control, and more particularly to a remote control device.

### BACKGROUND

Appliances, such as, televisions, air conditioners and stereos etc., are everywhere in modem life. For the convenience of users, these appliances are each configured with a remote control device (with which control of the appliances over a short distance may be implemented) by their manufacturers, before they leave the factory.

Existing remote control devices when in use, are powered by a dry battery. Since electric energy stored in a dry battery is limited, a user has to replace the dry battery periodically, resulting in a vast waste of resources. Moreover, the dry battery often includes heavy metals, such as, mercury, manganese, cadmium and lead etc.. As there is corrosion of the outer case of the dry battery, these heavy metals gradually go deep into the soil and groundwater, leading to environmental pollution. Therefore, in order to save resources and protect the environment, a new remote control device is in urgent need.

### SUMMARY

A remote control device is provided in the disclosure. The remote control device includes a shell, which is configured with a thermoelectric generation module, a central processor, a button module and a radio frequency (RF) module. The thermoelectric generation module is connected with each of the central processor, the button module and the RF module. The central processor is connected with the button module and the RF module. The thermoelectric generation module includes an electricity generation unit. The electricity generation unit includes two metal sheets which are made of different materials. The two metal sheets form a closed loop circuit via two connection points. The electricity generation unit is able to generate a thermoelectromotive force based on a temperature difference between the two connection points, and powers the central processor, the button module and the RF module by the thermoelectromotive force.

In another embodiment of the disclosure, the remote control device may further include an energy storage module, which is connected with the thermoelectric generation module.

In another embodiment of the disclosure, the energy storage module may be a storage capacitor.

In another embodiment of the disclosure, the remote control device may further include an energy indicator which is connected with the energy storage module. The energy indicator has two states of light-up and turn-off. When there is no electric energy stored in the energy storage module, the energy indicator is turn-off; and when there is electric energy stored in the energy storage module, the energy indicator is light-up.

In another embodiment of the disclosure, the remote control device may further include a Universal Serial Bus (USB) interface, which is connected with the energy storage module.

In another embodiment of the disclosure, the button module may be configured with a plurality of buttons, each of which indicates a function of the remote control device.

In another embodiment of the disclosure, the thermoelectric generation module further may further include a rectification unit and a stabilivolt unit. The rectification unit is connected with the electricity generation unit. One end of the stabilivolt unit is connected with the rectification unit, and the other end of the stabilivolt unit is connected with each of the central processor, the button module and the RF module.

In another embodiment of the disclosure, the two metal sheets in the electricity generation unit may be made of titanium alloys or aluminium alloys.

In another embodiment of the disclosure, the RF module may include one of a Bluetooth module, a wireless local area network or WiFi (registered trade mark) module, an infrared module, and a Near Field Communication (NFC) module.

In another embodiment of the disclosure, the remote control device may further include a switch and a jacklight. The jacklight is connected with the switch, and the switch is connected with the energy storage module.

Technical solutions of embodiments of the disclosure may provide at least some of the following beneficial effects.

The remote control device provided in the disclosure may use the built-in thermoelectric generation module to power the other function modules without a need of external power supply, such as a dry battery. This solution saves resources and avoids environment pollution, since the electricity is generated based on thermal energy which is pollution free.

It is to be understood that both the forgoing general description and the following detailed description are exemplary and interpretative only, and are not restrictive of the present disclosure.

### BRIEF DESCRIPTION OF THE DRAWINGS

The accompanying drawings, which are incorporated in and constitute a part of this specification, illustrate embodiments consistent with the disclosure and, together with the description, serve to explain the principles of the disclosure.
Fig. 1 is a schematic structural diagram showing a remote control device according to an exemplary embodiment.
Fig. 2 is a schematic structural diagram showing a thermoelectric generation module according to an exemplary embodiment.
Fig. 3 is a schematic structural diagram showing an electricity generation unit according to an exemplary embodiment.
Fig. 4 is a schematic structural diagram showing a thermoelectric generation module according to an exemplary embodiment.
Fig. 5 is a schematic structural diagram showing a remote control device according to an exemplary embodiment.
Fig. 6 is a schematic structural diagram showing a remote control device according to an exemplary embodiment.
Fig. 7 is a schematic structural diagram showing a remote control device according to an exemplary embodiment.

In the drawings, meanings of the reference numbers are as follows: 1. shell; 2. central processor; 3. thermoelectric generation module; 4. button module; 5. RF module; 6. energy storage module; 7. energy indicator; 8. USB interface; 9. Light or jacklight; 10. switch; 31. electricity generation unit; 32. rectification unit; 33. stabilivolt unit; 311. metal sheet of a kind of material; 312. another metal sheet of another kind of material; A. first connection point; and B. second connection point.

### DETAILED DESCRIPTION

Reference will now be made in detail to exemplary embodiments, examples of which are illustrated in the accompanying drawings. The following description refers to the accompanying drawings in which same reference numbers in different drawings represent same or similar elements unless otherwise described. The implementations set forth in the following description of exemplary embodiments do not represent all implementations consistent with the disclosure. Instead, they are merely examples of devices and methods consistent with aspects related to the disclosure as recited in the appended claims.

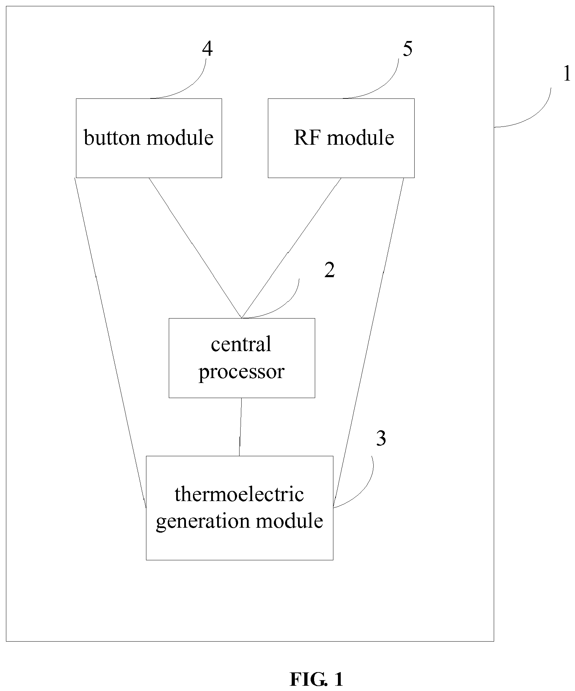

In order to solve the problem of resource waste and environment pollution caused by replacements of the external power supply (such as, a dry battery) for the existing remote control device, a remote control device is provided in the embodiments of the disclosure. The remote control device is based on the Seebeck effect, i.e., a closed loop circuit is formed by connecting two different types of metals; and when the temperatures at two connection points of the closed loop circuit are different, a thermoelectromotive force is generated. Then the remote control device may be powered based on the thermoelectromotive force. Referring to Fig. 1, the remote control device may include a shell 1. The shell 1 is configured with or comprises a thermoelectric generation module 3, a central processor 2, a button module 4 and a radio frequency (RF) module 5.

The thermoelectric generation module 3 is connected with each of the central processor 2, the button module 4 and the RF module 5. The thermoelectric generation module 3 may supply electric power to the remote control device. The central processor 2 is connected with the button module 4 and the RF module 5. The central processor 2 may control operations of each of the function modules of the remote control device. The button module 4 may detect a push-button operation from a user, and send the detected push-button operation to the central processor 2. The RF module 5 may transmit an instruction generated by the central processor 2 based on the push-button operation to an appliance paired with the remote control device.

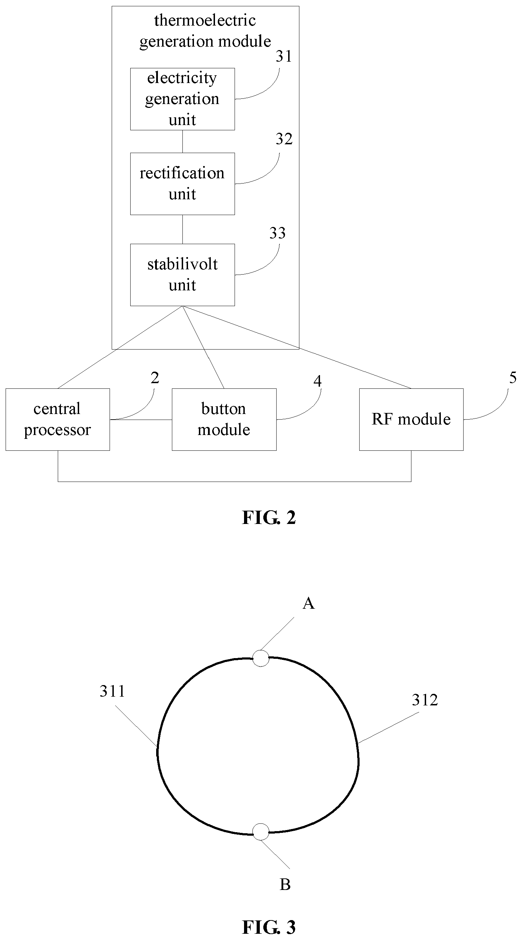

Referring to Fig. 2, the thermoelectric generation module 3 may include an electricity generation unit 31. Referring to Fig. 3, the electricity generation unit 31 includes two metal sheets 311 and 312 which are made of different materials. The metal sheet 311 and metal sheet 312 may be connected end to end to form a first connection point A and a second connection point B. The first connection point A is positioned within a holding area of the remote control device, while the second connection point B is positioned out of the holding area. The metal sheet 311 and metal sheet 312 forms a closed loop circuit via the first connection point A and second connection point B. when a user holds the remote control device, the temperature of the first connection point A becomes higher than the temperature of the second connection point B. When there is a temperature difference between the first connection point A and the second connection point B, the electricity generation unit 31 may generate a thermoelectromotive force, and power the central processor 2, the button module 4 and the RF module 5 connected with it utilizing the thermoelectromotive force.

Operating principles of the remote control device when in particular use are as follows.

When a user wants to use the remote control device to control a paired appliance, the user holds the remote control device, such that the temperature of the first connection point A within the holding area increases and thus become higher than the temperature of the second connection point B. At that moment, a thermoelectromotive force may be generated between the first connection point A and the second connection point B, which may be used to power the central processor 2, the button module 4 and the RF module 5. When the button module 4 detects a push-button operation from the user, it sends the detected push-button operation to the central processor 2. The central processor 2 generates, according to the button pushed by the user, a corresponding control command, and sends the control command to the RF module 5. The RF module 5 transmits the control command to the appliance paired with the remote control device, so as to accomplish control of the appliance.

The remote control device provided in the embodiments of the disclosure may use the built-in thermoelectric generation module to power the other function modules without needing an external power supply, such as a dry battery. This solution saves resources and avoids environment pollution, since the electricity is generated based on thermal energy which is pollution free.

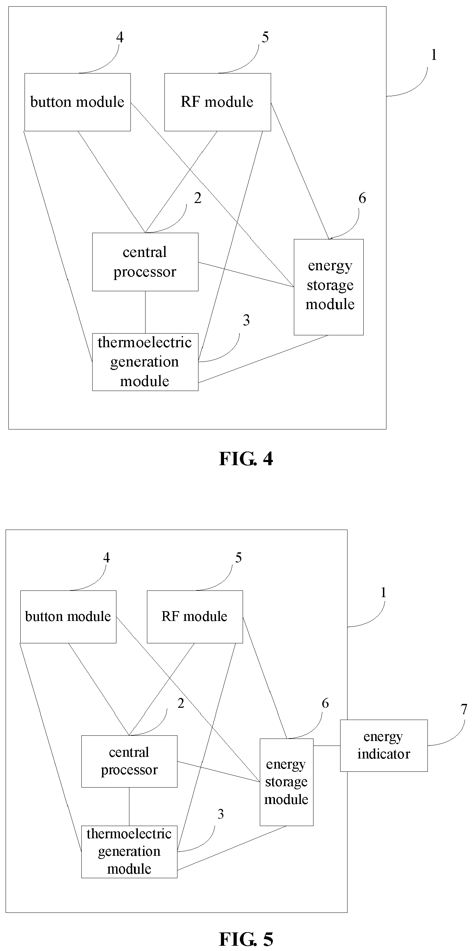

On the basis of structure of the remote control device illustrated in Fig. 1, a remote control device is provided in another embodiment of the disclosure. Referring to Fig. 4, the remote control device may further include an energy storage module 6, which is connected with the thermoelectric generation module 3, the central processor 2, the button module 4 and the RF module 5. The energy storage module 6 may be a storage capacitor with a large capacity. In an embodiment of the disclosure, at the beginning, a user holds the remote control device, the thermoelectric generation module 3 generates a relatively large thermoelectromotive force. A portion of the thermoelectromotive force may be used to supply electric power to the other function modules, and the remaining portion of the thermoelectromotive force may be stored in the energy storage module 6. With the time duration when the user holds the remote control device becomes longer and longer, the thermoelectromotive force generated by the thermoelectric generation module 3 becomes smaller gradually. When the temperature of the first connection point A is equivalent to the temperature of the second connection point B, the thermoelectric generation module 3 will stop the generation of electric energy, and then the remote control device is powered by the energy storage module 6.

On the basis of structure of the remote control device illustrated in Fig. 4, a remote control device is provided in another embodiment of the disclosure. Referring to Fig. 5, the remote control device may further include an energy indicator 7, which is connected with the energy storage module 6. The energy indicator 7 has two states of light-up and turn-off. When there is no electric energy stored in the energy storage module 6, the energy indicator 7 is turn-off; and when there is electric energy stored in the energy storage module 6, the energy indicator 7 is light-up.

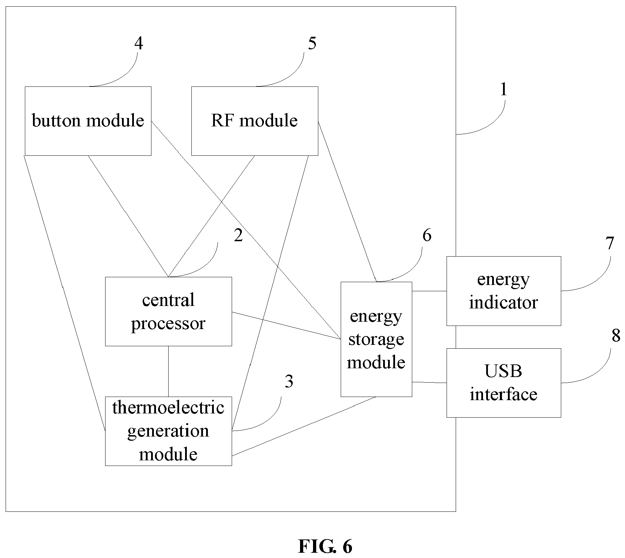

On the basis of structure of the remote control device illustrated in Fig. 5, a remote control device is provided in another embodiment of the disclosure. Referring to Fig. 6, the remote control device may further include a Universal Serial Bus (USB) interface 8, which is connected with the energy storage module 6. When a power supply is connected via the USB interface 8, it may charge the energy storage module 6.

In order to facilitate push-button operation of a user, the button module 5 may be further configured with a plurality of buttons. Each of the buttons indicates a function of the remote control device. Each function controls the appliance paired with the remote control device to perform an operation. For example, if the appliance is an intelligent speaker, the button module of the remote control device may be configured with a "switch button", a "state transition button", a "volume adjustment button" and so on. The "switch button" may control the intelligent speaker to be turned on or turned off. The "state transition button" may control the intelligent speaker to transit its state. The "volume adjustment button" may control the intelligent speaker to adjust its volume.

Generally, the electric energy generated by the thermoelectric generation module 3 is not stable. In order to achieve a steady direct current (DC), the thermoelectric generation module 3 may further include a rectification unit 32 and a stabilivolt unit 33. The stabilivolt unit is, for example, a gas tube. It maintains a constant voltage drop across its terminals over a wide range of voltages. The voltage drop is largely independent of current. The rectification unit 32 is connected with the electricity generation unit 31. One end of the stabilivolt unit 33 is connected with the rectification unit 32, and the other end of the stabilivolt unit 33 is connected with each of the central processor 2, the button module 4 and the RF module 5.

In another embodiment of the disclosure, the two metal sheets in the electricity generation unit 31 may be made of titanium alloys. For example, one metal sheet 311 is made of the alloy of titanium and a first metal, and the other metal sheet 312 is made of the alloy of titanium and a second metal which is different from the first metal. The two metal sheets in the electricity generation unit 31 may also be made of aluminium alloys. For example, one metal sheet 311 is made of the alloy of aluminium and a third metal, and the other metal sheet 312 is made of the alloy of titanium and a fourth metal which is different from the third metal.

In another embodiment of the disclosure, the RF module may be one of a Bluetooth module, a wireless local area network module such as a WiFi (registered trade mark module, an infrared module, and a Near Field Communication (NFC) module. Upon reception of an instruction send by the central processor, the RF module may transmit the instruction to the appliance paired with the remote control device in the form of any one of a Bluetooth signal, a WiFi signal, or an infrared signal; or the RF module may transmit the instruction to the appliance paired with the remote control device by an NFC data channel established with the appliance.

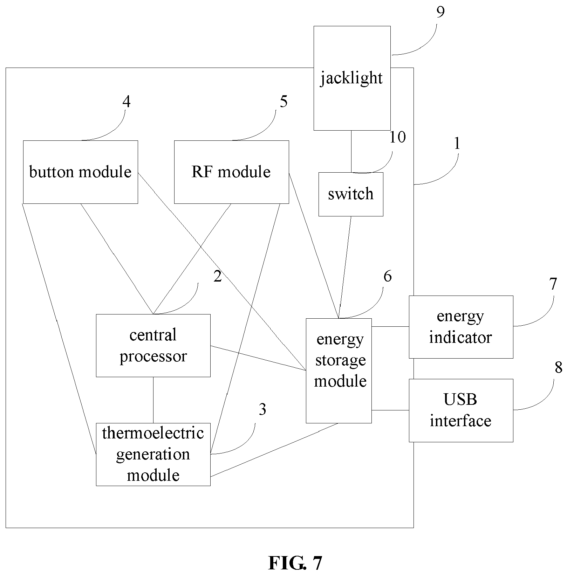

On the basis of the structure of the remote control device illustrated in Fig. 5, a remote control device is provided in another embodiment of the disclosure. Referring to Fig. 7, the remote control device may further include a switch 10 and a light or j acklight 9. The light 9 is used for lighting. The light 9 is connected with the switch 10. The switch 10 is connected with the energy storage module 6. In order to facilitate the user to observe the state of the switch 10, the switch 10 is configured with two indicators corresponding to an "on" state and an "off' state, respectively. When the user holds the remote control device and turns on the switch 10, the energy storage module 6 may power the light to provide lighting for the user.

The remote control device provided in the embodiments of the disclosure may use the built-in thermoelectric generation module to power the other function modules without a need of external power supply, such as a dry battery. This solution saves resources and avoids environment pollution, since the electricity is generated based on thermal energy which is pollution free.

Other embodiments of the disclosure will be apparent to those skilled in the art from consideration of the specification and practice of the disclosure herein. This application is intended to cover any variations, uses, or adaptations of the disclosure following the general principles thereof and including such departures from the present disclosure as come within known or customary practice in the art. It is intended that the specification and embodiments should be considered as exemplary only, with a true scope of the disclosure being indicated by the following claims.

It will be appreciated that the inventive concept is not limited to the exact construction that has been described above and illustrated in the accompanying drawings, and that various modifications and changes can be made without departing from the scope thereof. It is intended that the scope of the disclosure only is limited by the appended claims.

## Claims

1. A remote control device comprising:
a shell (1) comprising a thermoelectric generation module (3), a central processor (2), a button module (4) and a radio frequency (RF) module (5), wherein the thermoelectric generation module (3) is connected with each of the central processor (2), the button module (4) and the RF module (5), and the central processor (2) is connected with the button module (4) and the RF module (5);
wherein the thermoelectric generation module (3) comprises an electricity generation unit (31), and the electricity generation unit (31) comprises two metal sheets (311 and 312) which are made of different materials and form a closed loop circuit via two connection points (A and B), and
wherein the electricity generation unit (31) is able to generate a thermoelectromotive force based on a temperature difference between the two connection points (A and B), and powers the central processor (2), the button module (4) and the RF module (5) by the thermoelectromotive force.

2. The remote control device of claim 1, further comprising an energy storage module (6), which is connected with the thermoelectric generation module (3).

3. The remote control device of claim 2, wherein the energy storage module (6) is a storage capacitor.

4. The remote control device of claim 2 or claim 3, further comprising an energy indicator (7), which is connected with the energy storage module (6) and has two states of light-up and turn-off; wherein
the energy indicator (7) is turn-off when there is no electric energy stored in the energy storage module(6); and
the energy indicator (7) is light-up when there is electric energy stored in the energy storage module(6).

5. The remote control device according to any preceding claim, further comprising a Universal Serial Bus (USB) interface (8), which is connected with the energy storage module (6).

6. The remote control device according to any preceding claim, wherein the button module (4) is configured with a plurality of buttons, each of which indicates a function of the remote control device.

7. The remote control device according to any preceding claim, wherein the thermoelectric generation module (3) further comprises a rectification unit (32) and a stabilivolt unit (33), wherein the rectification unit (32) is connected with the electricity generation unit (31), one end of the stabilivolt unit (33) is connected with the rectification unit (32), and the other end of the stabilivolt unit (33) is connected with each of the central processor (2), the button module (4) and the RF module (5).

8. The remote control device according to any preceding claim, wherein the two metal sheets (311 and 312) in the electricity generation unit (31) are made of titanium alloys or aluminium alloys.

9. The remote control device according to any preceding claim, wherein the RF module (5) comprises one of a Bluetooth (registered trade mark) module, a wireless local area network module such as a WiFi (registered trade mark) module, an infrared module, and a Near Field Communication (NFC) module.

10. The remote control device according to any of claims 1 to 4 or claims 5 to 9 when dependent on any of claims 2 to 4, further comprising a switch (10) and a light (9), wherein the light (9) is connected with the switch (10), and the switch (10) is connected with the energy storage module (6).
